# EUROPEAN PATENT APPLICATION

(11) **EP 2 821 456 A1**
(43) Date of publication of application: **07.01.2015**
(21) Application number: 13754252.8
(22) Date of filing: 28.02.2013
(51) Int. Cl.: C09K 5/08, C08K 7/16, C08L 83/05, C08L 83/07, H01L 23/373

(54) **PUTTY-LIKE HEAT TRANSFER MATERIAL AND METHOD FOR PRODUCING SAME**

(30) Priority: 02.03.2012 JP 2012046785
(71) Applicant: Fuji Polymer Industries Co., Ltd., Nagoya-shi, Aichi 460-0012 (JP)
(72) Inventor: HATTORI Masakazu, Aichi 470-0533 (JP)
(74) Representative: Golding, Louise Ann
(86) International application number: PCT/JP2013/055494
(87) International publication number: WO 2013/129600

(57) **Abstract**

A putty-like heat transfer material of the present invention includes heat conductive particles dispersed in an organopolysiloxane. The organopolysiloxane is a silicone sol produced by partially crosslinking a base polymer (a) with a crosslinking component (b). The base polymer (a) includes an organopolysiloxane that contains an average of two or more alkenyl groups each bound to a silicon atom located at a terminal of a molecular chain in a molecule. The crosslinking component (b) includes an organopolysiloxane that contains an average of two or more hydrogen atoms each bound to a silicon atom in a molecule, and the partial crosslinking is carried out at such a ratio that the amount of the crosslinking component (b) is less than 1 mol with respect to 1 mol of the alkenyl groups bound to silicon atoms contained in the component (a). Thus, the present invention provides a putty-like heat transfer material that can exhibit favorable fluidity even when a large amount of inorganic particulate filler is added, that can be extruded readily through a tube or a syringe, and that can have a self shape retention when being allowed to stand. The present invention provides also a method for producing the putty-like heat transfer material.

## Description

### Technical Field

The present invention relates to a putty-like heat transfer material to be interposed between a heat generator such as a heat-generating electronic part and a radiator such as a heat sink, and a method for producing the same.

### Background Art

Recently, electronic equipment such as thin television sets, personal computers, digital cameras, electroluminescence devices and LED is required to exhibit higher performance and thus, numbers of heat-generating electronic parts are assembled at higher density in a smaller packaging area. Thereby, heat transfer materials to fill the minute disparities in the heat-generating electronic parts and to radiate heat towards the heat sink also are required to have a higher thermal conductivity.

As a heat transfer material to be interposed between a heat-generating electronic part mounted on a board and a radiator such as a heat sink, a grease made of a crosslinked silicone gel has been suggested (Patent document 1). Patent document 2 suggests a composition prepared by mixing a curable polymer gel and particulate filler and using the mixture to fill a container having an orifice, where the curable gel component extruded from the orifice will not be cured further. Patent document 3 suggests a composition prepared by adding powders of aluminum nitride and zinc oxide in the range of 500 to 1,000 weight parts in total with respect to 100 weight parts of a liquid silicone.

However, since Patent documents 1 and 2 use gels, the composition is stiff and difficult to extrude from a tube or a syringe. Moreover, it is difficult to increase the content of the inorganic particulate filler because the addition of a large amount of inorganic particulate filler would degrade the fluidity. Since a liquid silicone is used in Patent document 3, a favorable self shape retention would not be realized when being allowed to stand.

### Prior Art Documents

### Patent documents

Patent document 1: JP 4796704
Patent document 2: USP 7208192
Patent document 3: JP H10(1998)-110179 A

### Disclosure of Invention

### Problem to be Solved by the Invention

For solving the above-described problems in the conventional technique, the present invention provides a putty-like heat transfer material that exhibits favorable fluidity even if a large amount of inorganic particulate filler is added. The putty-like heat transfer material is extruded readily from a tube or a syringe, and it has a self shape retention when being allowed to stand. The present invention provides also a method for producing the putty-like heat transfer material.

### Means for Solving Problem

The putty-like heat transfer material of the present invention is a putty-like heat transfer material including heat conductive particles dispersed in an organopolysiloxane. It is characterized in that the organopolysiloxane is a silicone sol produced by partially crosslinking a base polymer (a) with a crosslinking component (b), where the base polymer (a) includes an organopolysiloxane that contains an average of two or more alkenyl groups each bound to a silicon atom located at a terminal of a molecular chain in a molecule; and the crosslinking component (b) includes an organopolysiloxane that contains an average of two or more hydrogen atoms each bound to a silicon atom in a molecule, and the partial crosslinking is carried out at such a ratio that the amount of the crosslinking component (b) is less than 1 mol with respect to 1 mol of the alkenyl groups bound to silicon atoms contained in the component (a).

The method for producing a putty-like heat transfer material of the present invention is characterized in that the material is a silicone sol produced by mixing and partially crosslinking components including the following (a) to (d).
(a) base polymer: 100 mass parts of organopolysiloxane containing an average of two or more alkenyl groups each bound to a silicon atom located at a terminal of a molecular chain in a molecule;
(b) crosslinking component: less than 1 mol of organopolysiloxane containing an average of two or more hydrogen atoms each bound to a silicon atom in a molecule, with respect to 1 mol of the alkenyl groups bound to silicon atoms contained in the component (a);
(c) a platinum-based metal catalyst: 0.01 to 1,000 ppm in mass unit with respect to the component (a); and
(d) heat conductive particles: in the content of 100 to 2,000 mass parts with respect to 100 mass parts of the silicone sol.

### Effects of the Invention

The present invention provides a silicone sol by reducing the ratio of a crosslinking component of a silicone polymer so as to lower the crosslinking density and to allow partial crosslinking, thereby providing a putty-like heat transfer material that exhibits favorable fluidity even if a large amount of inorganic particulate filler is added. The putty-like heat transfer material is extruded readily from a tube or a syringe and it has a self shape retention when being allowed to stand. Furthermore, the heat conductive particles include at least two types of inorganic particles having different average particle diameters, and on the surfaces of the inorganic particles having a relatively smaller average particle diameter, a certain silane compound or a partial hydrolyzate thereof may be chemically bound. This enhances the effect provided by the silicone sol. Namely, the thus obtained putty-like heat transfer material exhibits favorable fluidity even if the content of the inorganic particulate filler is increased further. It is extruded readily from a tube or a syringe and has a self shape retention when being allowed to stand.

### Brief Description of Drawings

[FIG. 1] FIGs. 1A and 1B are schematic cross-sectional views showing an example of the use of a putty-like heat transfer material in one Example of the present invention.
[FIG. 2] FIG. 2A is a schematic explanatory view of a polymer of a putty-like heat transfer material and heat conductive inorganic particles (filler) in one Example of the present invention. FIG. 2B is a similar schematic explanatory view of a Comparative Example corresponding to FIG. 2A.

### Description of the Invention

A putty-like heat transfer material of the present invention includes heat conductive particles dispersed in a partially crosslinked silicone sol. The partial crosslinking is carried out in the method of the present invention by determining that the crosslinking component (b) (organosiloxane containing an average of two or more hydrogen atoms each bound to a silicon atom in a molecule) would be less than 1 mol with respect to 1 mol of the alkenyl groups bound to silicon atoms contained in the component (a). Preferably, the content of the organopolysiloxane is 0.1 to 0.8 mol, and more preferably 0.1 mol or more and less than 0.5 mol. That is, by reducing the ratio of the crosslinking component, it is possible to lower the crosslinking density so as to provide a putty-like heat transfer material that keeps favorable fluidity. The putty-like heat transfer material is extruded readily from a tube or a syringe, and it has a self shape retention when being allowed to stand. The properties of the material, namely the fluidity during extrusion from a tube or a syringe and the self shape retention when being allowed to stand after the extrusion, are useful from the viewpoint of workability and efficiency at the time of assembling electronic parts or the like.

The silicone sol in the present invention can be confirmed to be a sol since it dissolves in solvents such as xylene, octane, ethyl acetate, dichloroethane, paraffin and the like. These solvents are the solvents for ordinary silicone rubbers. According to a general chemical dictionary, a gel does not dissolve in any solvents, and thus it can be distinguished from a sol. Further, a gel is a material changed from a viscous fluid to an elastic solid, and thus a problem thereof is its low fluidity in general. Since a partially crosslinked silicone sol (viscous fluid) is used in the present invention, the fluidity is favorable even if a larger amount of inorganic particulate filler is added.

The putty-like heat transfer material of the present invention exhibits fluidity for extrusion and also has a self shape retention. That is, when shearing force is applied, the material can be extruded readily from a tube or a syringe since the fluidity is favorable. And, after being extruded from a tube or a syringe, the putty-like heat transfer material has a self shape retention when being allowed to stand and keeps its morphological stability between a heat-generating part and a heat-dissipating material.

It is preferable that the putty-like heat transfer material of the present invention has a viscosity in the range of 100 Pa•s to 4,000 Pa•s at a shear rate of 0.2 to 5.0/s. The shear rate of 0.2 to 5.0/s corresponds to a shear applied for extruding the material from a tube or a syringe at the time of mounting an electronic part or the like. Further, after extrusion from a tube or a syringe, the viscosity may be increased over time in the air. The property is preferable from the viewpoint of the self shape retention.

It is preferable that the heat conductive particles of the present invention includes inorganic particles having an average particle diameter of 2 µm or more and inorganic particles having an average particle diameter of less than 2 µm, and that the content of the inorganic particles having an average particle diameter of 2 µm or more is 50 mass% or more when the entire particles are 100 mass%, since it is possible to mix a large amount of the inorganic particles if the average particle diameter of the particles is 2 µm or more.

The thermal conductivity of the putty-like heat transfer material of the present invention is preferably in the range of 0.2 to 10 W/mK, and more preferably 0.3 to 9 W/mK. When the thermal conductivity is within this range, effective thermal conductivity from the heat-generating part to the heat dissipating material can be maintained.

It is preferable that the inorganic particles are formed of at least one material selected from the group consisting of alumina, zinc oxide, magnesium oxide, aluminum nitride, boron nitride, aluminum hydroxide and silica, because the materials are inexpensive and have high thermal conductivity. Due to the similar reason, it is preferable that the alumina is an α-alumina with a purity of 99.5 mass% or more.

It is preferable that the putty-like heat transfer material is filled in either a tube or a syringe, since these elements are used for mounting electronic parts.

It is preferable that an inorganic particulate pigment further is added to the putty-like heat transfer material. If the putty-like heat transfer material is colored with the inorganic particulate pigment, the application state can be determined clearly.

A putty-like heat transfer material of the present invention is obtained by mixing and crosslinking the components including (a) to (d) below.
(a) base polymer: 100 mass parts of organopolysiloxane containing an average of two or more alkenyl groups each bound to a silicon atom located at a terminal of a molecular chain in a molecule;
(b) crosslinking component: less than 1 mol of organopolysiloxane containing an average of two or more hydrogen atoms each bound to a silicon atom in a molecule, with respect to 1 mol of the alkenyl groups bound to silicon atoms contained in the component (a);
(c) a platinum-based metal catalyst: 0.01 to 1,000 ppm in mass unit with respect to the component (a); and
(d) heat conductive particles: in the content of 100 to 2,000 mass parts with respect to 100 mass parts of the silicone sol (base polymer + crosslinking component).
(e) Further, alkyltrialkoxysilane may be added to the silicone sol component.
(f) Further, 0.5 to 10 mass parts of inorganic particulate pigment may be added to 100 mass parts of the silicone sol component.

### (a) Alkenyl group-containing organopolysiloxane

The component (a) of the present invention is an organopolysiloxane containing two or more alkenyl groups each bound to a silicon atom in a molecule, and the organopolysiloxane containing two alkenyl groups is the main ingredient (base polymer component) in the silicone rubber composition of the present invention. The organopolysiloxane has two alkenyl groups such as vinyl groups, allyl groups or the like whose carbon number is 2 to 8, particularly, 2 to 6, bound to silicon atoms in a molecule. It is desirable that the viscosity at 25°C is 10 to 1,000,000 mPa•s, in particular 100 to 100,000 mPa•s from the viewpoint of workability, curing property and the like.

Specifically, organopolysiloxane as expressed by the General formula (Chemical formula 1) below is used. The organopolysiloxane contains an average of two or more alkenyl groups each bound to a silicon atom located at a terminal of a molecular chain in a molecule. The side chain is a linear organopolysiloxane blocked with a triorganosiloxy group. It is desirable that the viscosity at 25°C is 10 to 1,000,000 mPa•s from the viewpoint of workability, curing property and the like. The linear organopolysiloxane may contain a small amount of branched structure (trifunctional siloxane unit) in the molecular chain. In the present invention, organopolysiloxane that contains an average of two or more alkenyl groups each bound to a silicon atom located at a terminal of a molecular chain in a molecule is used for the purpose of providing a putty-like heat transfer material including a silicone polymer sol of high molecular weight. Such a putty-like heat transfer material exhibits favorable fluidity even if a large amount of inorganic particulate filler is added, and it is extruded readily from a tube or a syringe and has a self shape retention when being allowed to stand.

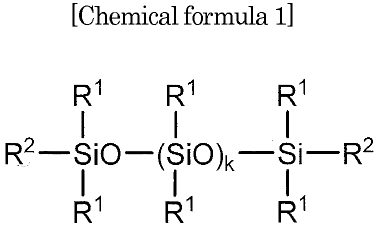

In the formula, R¹ are unsubstituted or substituted monovalent hydrocarbon groups that are identical to or different from each other and have no aliphatic unsaturated bond. R² is an alkenyl group, and k is 0 or a positive integer.

Here, it is preferable that R¹, namely, the unsubstituted or substituted monovalent hydrocarbon groups having no aliphatic unsaturated bond, has 1 to 10, particularly 1 to 6 carbon atoms. The specific examples include: alkyl groups such as a methyl group, an ethyl group, a propyl group, an isopropyl group, a butyl group, an isobutyl group, a tert-butyl group, a pentyl group, a neopentyl group, a hexyl group, a cyclohexyl group, an octyl group, a nonyl group, and a decyl group; aryl groups such as a phenyl group, a tolyl group, a xylyl group, and a naphthyl group; aralkyl groups such as a benzyl group, a phenylethyl group, and a phenylpropyl group; and materials prepared by substituting a part or all of the hydrogen atoms in these groups with halogen atoms such as fluorine, bromine, and chlorine, a cyano group and the like. The examples include halogen substituted alkyl groups such as a chloromethyl group, a chloropropyl group, a bromoethyl group, and a trifluoropropyl group; a cyanoethyl group and the like. For the R², namely, the alkenyl group, a group having 2 to 6, in particular 2 to 3 carbon atoms, is preferred. Specific examples include: a vinyl group, an allyl group, a propenyl group, an isopropenyl group, a butenyl group, an isobutenyl group, a hexenyl group, and a cyclohexenyl group. A vinyl group is preferred.

In the General formula (1), k is 0 or a positive integer satisfying 0 ≤ k ≤ 10,000 in general. Preferably, it is an integer satisfying 5 ≤ k ≤ 2,000, and more preferably 10 ≤ k ≤ 1,200.

For the organopolysiloxane of the component (a), organopolysiloxanes each having three or more alkenyl groups each bound to a silicon atom in a molecule may be used together. The number of the alkenyl groups is 3 to 30, and preferably 3 to about 20. The alkenyl group has 2 to 8, and in particular 2 to 6 carbon atoms, and the examples include a vinyl group and an allyl group. The molecular structure may be linear, cyclic, branched, or three-dimensionally reticular. Preferably, it is a linear organopolysiloxane having a main chain composed of repetitions of diorganosiloxane unit and the molecular chain is blocked at both terminals with triorganosiloxy groups, and it has a viscosity at 25°C in the range of 10 to 1,000,000 mPa•s and in particular, 100 to 100,000 mPa• s.

Each of the alkenyl groups is bound at least to a silicon atom located at a terminal of a molecular chain. Further, alkenyl groups bound to silicon atoms not located at terminals of a molecular chain (namely, located in the middle of the molecular chain) may be included. A particularly desirable example is a linear organopolysiloxane that has one to three alkenyl groups on each of the silicon atoms located at both terminals of a molecular chain represented by a General formula (Chemical formula 2) below (it should be noted that in a case where the total number of the alkenyl groups bound to the silicon atoms at the both terminals of the molecular chain is less than 3, at least one alkenyl group bound to a silicon atom not located at the terminal of the molecular chain (i.e., in the middle of the molecular chain) is included (as the substituent in the diorganosiloxane unit, for example)), which has a viscosity in the range of 10 to 1,000,000 mPa•s as mentioned above at 25°C from the viewpoint of workability, curing property and the like. The linear organopolysiloxane may contain in the molecular chain a small amount of branched structure (trifunctional siloxane unit).

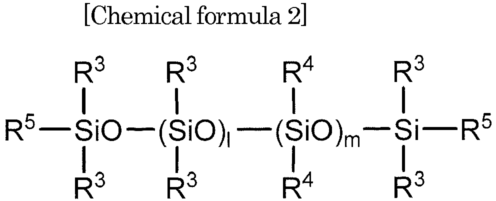

In the formula, R³ are unsubstituted or substituted monovalent hydrocarbon groups that are identical to or different from each other, and at least one of the R³ is an alkenyl group. R⁴ are unsubstituted or substituted monovalent hydrocarbon groups that are identical to or different from each other and have no aliphatic unsaturated bond; R⁵ is an alkenyl group; and, *l* and m are 0 or positive integers.

Here, it is preferable that R³, namely, the unsubstituted or substituted monovalent hydrocarbon groups has 1 to 10, particularly 1 to 6 carbon atoms. The specific examples include: alkyl groups such as a methyl group, an ethyl group, a propyl group, an isopropyl group, a butyl group, an isobutyl group, a tert-butyl group, a pentyl group, a neopentyl group, a hexyl group, a cyclohexyl group, an octyl group, a nonyl group, and a decyl group; aryl groups such as a phenyl group, a tolyl group, a xylyl group, and a naphthyl group; aralkyl groups such as a benzyl group, a phenylethyl group, and a phenylpropyl group; alkenyl groups such as a vinyl group, an allyl group, a propenyl group, an isopropenyl group, a butenyl group, a hexenyl group, a cyclohexenyl group, and an octenyl group; and materials prepared by substituting a part or all of the hydrogen atoms in these groups by halogen atoms such as fluorine, bromine, and chlorine, a cyano group and the like. The examples include halogen substituted alkyl groups such as a chloromethyl group, a chloropropyl group, a bromoethyl group, and a trifluoropropyl group; a cyanoethyl group and the like.

For R⁴, namely, the monovalent hydrocarbon group, a group having 1 to 10, in particular 1 to 6 carbon atoms, is preferred. And the examples are similar to the specific examples of the above R¹, although the alkenyl group is not included.

For R⁵, namely, the alkenyl group, a group having 2 to 6, in particular 2 to 3 carbon atoms is preferred. Specific examples are similar to those of R² in the above formula (Chemical formula 1). A vinyl group is preferred.

In the formula, l and m are 0 or positive integers satisfying 0 < l + m ≤ 10,000, preferably 5 < l + m ≤ 2,000, and more preferably 10 < l + m ≤ 1,200. They are integers satisfying 0 < l/(l + m) ≤ 0.2, and preferably 0.001 < l/(l + m) ≤ 0.1.

### (b) Organohydrogenpolysiloxane

The organohydrogenpolysiloxane of the component (b) of the present invention acts as a crosslinking agent. As a result of addition reaction (hydrosililation) of the SiH group in the component and the alkenyl group in the component (a), a cured material is formed. There is no particular limitation on the organohydrogenpolysiloxane as long as it has two or more hydrogen atoms each bound to a silicon atom (i.e., SiH group) in a molecule, and the molecular structure of the organohydrogenpolysiloxane may be linear, cyclic, branched or three-dimensionally reticular. The number of the silicon atoms in a molecule (i.e., degree of polymerization) can be 2 to 1,000, and particularly 2 to about 300.

There is no particular limitation on the locations of the silicon atoms to which the hydrogen atoms are to be bound, and the locations may be the terminals or not (in the middle) of the molecular chain. Examples of the organic groups bound to the silicon atoms other than the hydrogen atoms include unsubstituted or substituted monovalent hydrocarbon groups that do not have aliphatic unsaturated bond, which are similar to R¹ in the above General formula (Chemical formula 1).

Examples of the organohydrogenpolysiloxane of the component (b) include hydrogenorganosiloxanes having the following structures.

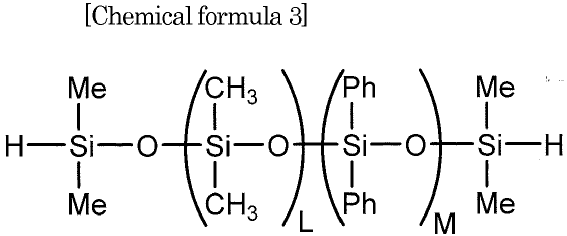

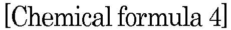

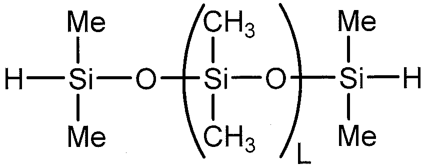

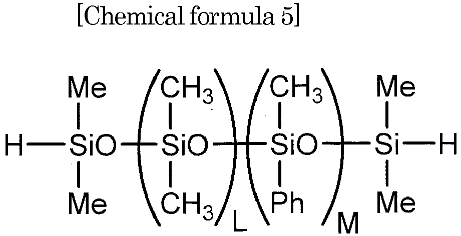

In the above formulae, Ph is an organic group including at least one of a phenyl group, an epoxy group, an acryloyl group, a methacryloyl group, and an alkoxy group. L is an integer in the range of 0 to 1,000, particularly 0 to 300. M is an integer in the range of 1 to 200.

Such an organohydrogenpolysiloxane can be obtained by equilibrating siloxane obtained by either hydrolysis or hydrolysis condensation of chlorosilane such as R⁵SiHCl₂, (R⁵)₃SiCl, (R⁵)₂SiCl₂, and (R⁵)₂SiHCl (in the formula, R⁵ is an alkyl group such as a methyl group and an ethyl group, or an aryl group such as a phenyl group) by a well-known process.

### (c) Platinum group metal-based catalyst

The platinum group metal-based catalyst of the component (c) in the present invention is blended to cause an addition-curing reaction to the composition of the present invention. Any catalysts known as catalysts for hydrosilylation reaction can be used. The catalysts may be platinum-based, palladium-based, or rhodium-based. From the viewpoint of the cost or the like, examples of available materials are platinum-based materials such as platinum, platinum black, and chloroplatinic acid. Specific examples thereof include platinum compounds such as H₂PtCl₆•mH₂O, K₂PtCl₆, KHPtCl₆·mH₂O, K₂PtCl₄, K₂PtCl₄•mH₂O, and PtO₂•mH₂O (m is a positive integer); complexes of these platinum compounds and hydrocarbons such as olefins, alcohols, or vinyl group-containing organopolysiloxanes. These can be used alone or as a combination of at least two.

### (d) Heat conductive particles

It is preferable that the component (d) of the present invention is added in the range of 100 to 2,000 mass parts with respect to 100 mass parts of a silicone rubber layer. Thereby, it is possible to make the thermal conductivity of the heat-dissipating sheet to be in the range of 0.2 to 10 W/mK. The material of the heat conductive particles is preferably at least one selected from the group consisting of alumina, zinc oxide, magnesium oxide, aluminum nitride, boron nitride, aluminum hydroxide and silica. Various shapes such as spherical, scales, and polyhedra can be employed. It is preferable that the specific surface area of the heat conductive particles is preferably in the range of 0.06 to 10 m²/g. The specific surface area is BET specific surface area, and the measurement is carried out in accordance with the method of JIS R1626. In a case of applying an average particle diameter, the preferred range is 0.1 to 100 µm. In measurement of the particle diameter, a laser diffracted light scattering method is applied to measure the 50% particle diameter. The measuring instrument is for example a laser diffraction/scattering particle size distribution analyzer "LA-950S2" manufactured by Horiba Ltd.

For the heat conductive particles, it is preferable to use together two types of inorganic particles having different average particle diameters. Thereby, the spaces between the heat conductive particles having a larger diameter are filled with the heat conductive inorganic particles having a smaller diameter, and thus, filling approximating the maximal density is obtained to enhance the thermal conductivity. It is preferable that the inorganic particles having relatively smaller average particle diameter are subjected to a surface treatment with a silane compound expressed as R(CH₃)ₐSi(OR')₃₋ₐ (R is an unsubstituted or substituted organic group having 6 to 20 carbon atoms, R' is an alkyl group having 1 to 4 carbon atoms, and *a* is 0 or 1) or a partial hydrolyzate thereof. Examples of the R(CH₃)ₐSi(OR')₃₋ₐ (R is an unsubstituted or substituted organic group having 6 to 20 carbon atoms, R' is an alkyl group having 1 to 4 carbon atoms, and *a* is 0 or 1) (hereinafter simply referred to as "silanes") include hexyltrimethoxysilane, hexyltriethoxysilane, octyltrimethoxysilane, octyltriethoxysilane, decyltrimetoxysilane, decyltriethoxysilane, dodecyltrimethoxysilane, dodecyltriethoxysilane, hexadodecyltrimethoxysilane, hexadodecyltriethoxysilane, octadecyltrimethoxysilane, and octadecyltriethoxysilane. Such silane compounds may be used singly or as a combination of two or more. Here, the surface treatment includes a covalent bond and furthermore, adsorption and the like. The inorganic particles having a relatively larger average particle diameter are the particles for example having an average particle diameter of 2 µm or more. Preferably, the content of the particles is 50 mass% or more when the entire particles are 100 mass%.

### (e) Other components

In the composition of the present invention, any components other than (a) to (d) can be blended as required. For example, an inorganic pigment such as colcothar and alkyltrialkoxysilane (for a surface treatment of the filler, for example) or the like may be added.

### (3) Partial crosslinking

The above-mentioned components (a)-(c) are crosslinked, and later, the component (d) is added thereto and mixed. The crosslinking is carried out at a temperature of 50 to 150°C for 0.1 to 1 hour. Preferably, it is carried out at a temperature of 80 to 100°C for 0.2 to 0.5 hours. In some cases, the component (e) may be heated and added to the component (d).

### (4) Container filling

The thus obtained partially-crosslinked silicone sol is filled in a tube, a syringe (dispenser) or the like. These are the containers suitable for automatic mounting of electronic parts.

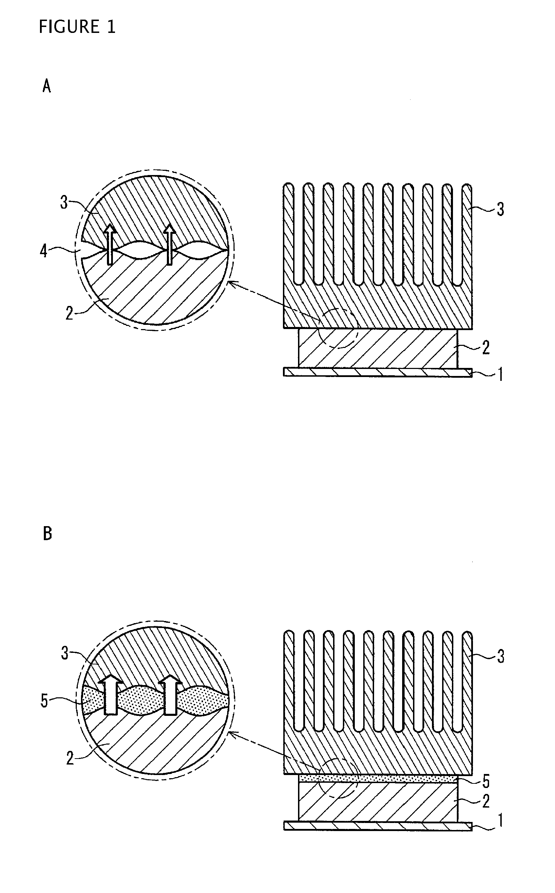

Next, the present invention is explained with reference to the attached drawings. FIGs. 1A and 1B are schematic cross-sectional views for showing an example of use of a putty-like heat transfer material in one Example of the present invention. As shown in FIG. 1A, an air gap 4 is formed between a heat-generating part 2 such as a semiconductor packaged on a printed board 1 and a heat sink (heat dissipater) 3. Since the air gap 4 is thermally insulating, it is filled with a putty-like heat transfer material 5 as shown in FIG. 1B. For example, the putty-like heat transfer material 5 is extruded from the tube or the syringe (dispenser) onto the heat-generating part 2, and the heat sink (heat dissipater) 3 is pressed thereon for filling. Since the putty-like heat transfer material 5 has a self shape retention when being allowed to stand, at the time of extrusion onto the heat-generating part 2, it retains the shape of an extruded material. When pressed with the heat sink (heat dissipater) 3, the pressed shape of the putty-like heat transfer material 5 is retained.

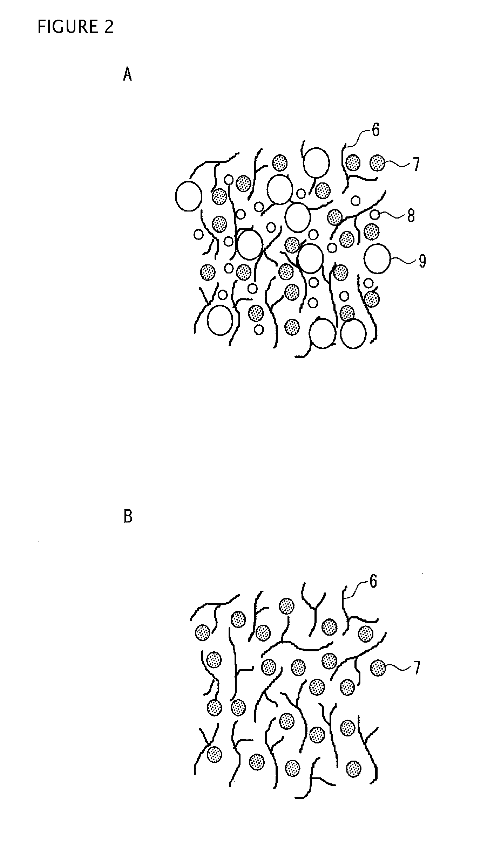

FIG. 2A is a schematic explanatory view of a polymer of putty-like heat transfer material and heat conductive inorganic particles (filler) in one Example of the present invention; and FIG. 2B is a similar schematic explanatory view for Comparative example. FIG. 2B shows an example where silicone sol molecules 6 and heat conductive inorganic particles 7 of a single particle diameter are mixed with each other. It is difficult to add a large amount of heat conductive inorganic particles 7 of a single particle diameter. In contrast, in the case of FIG. 2A, since the silicone sol molecules 6, heat conductive inorganic particles 8 having a small particle diameter, heat conductive inorganic particles 7 having a medium particle diameter, and heat conductive inorganic particles 9 having a large particle diameter are mixed with each other, the heat conductive inorganic particles are filled at the maximal density Thereby, the thermal conductivity can be enhanced. In addition to that, since the small and medium sized particles having larger surface areas are subjected to a surface treatment with a silane coupling agent, the fluidity can be retained even if a large amount of the particles are added.

### Examples

The present invention shall be described more specifically by way of Examples below, but the present invention is not limited to these Examples.

### <Measurement method>

(1) Thermal conductivity: measured according to the hot disk method (Kyoto Electronics Manufacturing Co., Ltd.) using an apparatus for measuring thermophysical properties: TPA-501 (trade name).
(2) Particle diameter of heat conductive inorganic particles
   In measurement of the particle diameter, laser diffracted light scattering method was applied to measure the 50% particle diameter. For the measuring instrument, a laser diffraction/scattering particle size distribution analyzer "LA-950S2" manufactured by Horiba Ltd was used.
(3) Self shape retention

The self shape retention was evaluated by extruding the putty-like heat transfer material from a tube or a syringe onto a glass plate so as to be formed as a sphere having a diameter of about 9 mm, and measuring the diameter of the sphere just after the extrusion, after 24 hours, 96 hours, and 168 hours respectively. In a case where each of the measurement values was within ±1 mm of the diameter just after the extrusion, the material was considered to have self shape retention.

### (Example 1)

### <Silicone component>

For the silicone component, a two-component room-temperature vulcanizing silicone rubber (two-component RTV) was applied. It was "CF5036" (trade name, manufactured by Dow Corning Toray Silicone Co., Ltd.)" including a solution-A and a solution-B. The solutions were dispensed such that the mass ratio of the solution-A to the solution-B would be 7:3. The solution-A includes a polysiloxane-based polymer component containing vinyl groups located at both terminals (it is called Vi group component) and a Pt catalyst component, where the content of the Vi group component is equal to the content of the Vi group component in the solution-B. The solution-B includes an organopolysiloxane that is a crosslinking component and that contains an average of two or more hydrogen atoms each bound to a silicon atom in a molecule (it is called Si-H group component) and a Vi group component, where the molar ratio of the Si-H group to the Vi group is 1:1. As a total of the solution-A and the solution-B, the ratio of the Si-H group to 1 mol of the Vi group was 0.3 mol. The components (a) to (c) of the present invention are added in advance to "CF5036".

### <Heat conductive inorganic particles>

For the heat conductive inorganic particles, alumina was dispensed in the following manner with respect to 100 mass parts of the silicone component.
(1) 600 mass parts of spherical alumina having an average particle diameter of 3 µm, subjected to a surface treatment with octyltriethoxysilane;
(2) 300 mass parts of alumina of unspecified shape having an average particle diameter of 0.3 µm, subjected to a surface treatment with octyltriethoxysilane;
(3) 500 mass parts of alumina of a precise share having an average particle diameter of 20 µm, not treated with a silane coupling agent.

### <Other additives>

For the coloring pigment, 1 mass part of a powder of ferric oxide (colcothar) was dispensed with respect to 100 mass parts of the silicone component.

### <Production of silicone sol>

The above-mentioned silicone component and the coloring pigment were introduced into a container and mixed with a stirrer. Later, the mixture was subjected to a partial crosslinking reaction at 100°C for 0.3 hours. Then, heat conductive inorganic particles were introduced and mixed using the stirrer, and thereby the silicone component turned to a silicon sol and thus a putty-like heat transfer material was obtained.

The thus obtained putty-like heat transfer material was extruded readily from a tube or a syringe, and it had a self shape retention when being allowed to stand. The physical properties were as follows.
Specific gravity: 3.2 (JIS K 6220, 25°C)
Viscosity: 2,000 Pa•s (Controlled rotational viscometer RotoVisco (RV1), 25°C, shear rate: 1/s)
Thermal conductivity: 3.2 W/m•K (ASTM D2326, hot disk method (TPA-501))

The thermal resistance values are shown in Table 1 below.

**[Table 1]**

| | Initial | | After 1000 hours | |
|---|---|---|---|---|
| | Thermal resistance value (°C•m²/W) | Viscosity (Pas) | Thermal resistance value (°C•cm²/W) | Viscosity (Pas) |
| 150°C continuous | 2.3 | 2000 | 2.5 | 4500 |
| -40°C continuous | | | 2.4 | 2000 |
| 60°C/90%RH continuous | | | 2.2 | 2400 |
| -40°C ⇔ 125°C thermal shock | | | 2.6 | 2800 |

The thus obtained putty-like heat transfer material was subjected to a dissolution test. The solvent was xylene. 2 g of the putty-like heat transfer material was collected and added to 10 ml of the xylene, which then was shaken for 5 minutes. As a result, the xylene turned to be whitish and the putty-like heat transfer material was dissolved. This result shows that the putty-like heat transfer material of this example is not a gel but a sol.

Next, a change in the viscosity of the putty-like heat transfer material was checked. The viscosity of the putty-like heat transfer material just after being extruded from a tube or a syringe was 2,000 Pa•s (Controlled rotational viscometer RotoVisco (RV1), 25°C, shear rate: 1/s) as mentioned above. After 24 hours, it was 2,100 Pa•s; after 96 hours, it was 2,200 Pa•s; and after 168 hours, it was 2,200 Pa•s. This result shows that in the putty-like heat transfer material of this Example, the viscosity increases from the extrusion up to 96 hours, and the viscosity does not change thereafter.

Next, the consistency of the putty-like heat transfer material was checked. The consistency was calculated by converting a value measured in accordance with JIS K2220. That is, the temperature is room temperature (23°C); the shape is 1/4 cone; and the test method is based on immiscible consistency (unworked penetration). The consistency of the putty-like heat transfer material obtained in Example 1 was 260.

### (Example 2)

The test was carried out similarly to Example 1 except that the ratio of the solution-A to the solution-B was set to 8:2. The organopolysiloxane containing an average of two or more hydrogen atoms each bound to a silicon atom in a molecule of the crosslinking component in the solution-B was 0.2 mol with respect to 1 mol of alkenyl groups bound to silicon atoms contained in the solution-A.

The thus obtained putty-like heat transfer material was extruded readily from a tube or a syringe, and it had a self shape retention when being allowed to stand. And it was dissolved in a dissolution test with respect to the solvent similar to that of Example 1. The physical properties were as follows.
Viscosity: 1,500 Pa•s (Controlled rotational viscometer RotoVisco (RV1), 25°C, shear rate: 1/s)
Thermal conductivity: 3.2 W/m•K (ASTM D2326, hot disk method (TPA-501))

### (Example 3)

The test was carried out similarly to Example 1 except that the ratio of the solution-A to the solution-B was set to 6:4. The organopolysiloxane containing an average of two or more hydrogen atoms each bound to a silicon atom in a molecule of the crosslinking component in the solution-B was 0.4 mol with respect to 1 mol of alkenyl groups bound to silicon atoms contained in the solution-A.

The thus obtained putty-like heat transfer material was extruded readily from a tube or a syringe, and it had a self shape retention when being allowed to stand. And it was dissolved in a dissolution test with respect to the solvent similar to that of Example 1. The physical properties were as follows.
Viscosity: 4,000 Pa•s (Controlled rotational viscometer RotoVisco (RV1), 25°C, shear rate: 1/s)
Thermal conductivity: 3.2 W/m•K (ASTM D2326, hot disk method (TPA-501))

### (Comparative Example 1)

The test was carried out similarly to Example 1 except that the solution-B was organopolysiloxane (Si-H group component) that was a crosslinking component and that contained an average of two or more hydrogen atoms each bound to a silicon atom in a molecule and the ratio of the solution-A to the solution-B was set to 5:5. The organopolysiloxane containing an average of two or more hydrogen atoms each bound to a silicon atom in a molecule of the crosslinking component in the solution-B was 1.0 mol with respect to 1 mol of alkenyl groups bound to silicon atoms contained in the solution-A.

It was difficult to extrude the thus obtained material from a tube or a syringe. The physical properties were as follows.
Viscosity: the hardness was so high and not measurable (Controlled rotational viscometer RotoVisco (RV1), 25°C, shear rate: 1/s)
Thermal conductivity: 3.2 W/m•K (ASTM D2326, hot disk method (TPA-501))

### (Example 4)

The test was carried out similarly to Example 1 except that the ratio of the solution-A to the solution-B was set to 8.7:1.3. The organopolysiloxane containing an average of two or more hydrogen atoms each bound to a silicon atom in a molecule of the crosslinking component in the solution-B was 0.13 mol with respect to 1 mol of alkenyl groups bound to silicon atoms contained in the solution-A.

The thus obtained putty-like heat transfer material was extruded readily from a tube or a syringe, and it had a self shape retention when being allowed to stand. And it was dissolved in a dissolution test with respect to the solvent similar to that of Example 1. The physical properties were as follows.
Viscosity: 1,400 Pa•s (Controlled rotational viscometer RotoVisco (RV1), 25°C, shear rate: 1/s)
Thermal conductivity: 3.2 W/m•K (ASTM D2326, hot disk method (TPA-501))

### (Example 5)

The test was carried out similarly to Example 1 except that the ratio of the solution-A to the solution-B was set to 5.4:4.6. The organopolysiloxane containing an average of two or more hydrogen atoms each bound to a silicon atom in a molecule of the crosslinking component in the solution-B was 0.46 mol with respect to 1 mol of alkenyl groups bound to silicon atoms contained in the solution-A.

The thus obtained putty-like heat transfer material was extruded readily from a tube or a syringe, and it had a self shape retention when being allowed to stand. And it was dissolved in a dissolution test with respect to the solvent similar to that of Example 1. The physical properties were as follows.
Viscosity: 17,000 Pa•s (Controlled rotational viscometer RotoVisco (RV1), 25°C, shear rate: 1/s)
Thermal conductivity: 3.2 W/m•K (ASTM D2326, hot disk method (TPA-501))

### Explanation of Letters and Numerals

- 1:: Printed board
- 2:: Heat-generating part
- 3:: Heat sink (heat dissipater)
- 4:: Air gap
- 5:: Putty-like heat transfer material
- 6:: Silicone sol molecule
- 7,8,9:: Heat conductive inorganic particles

## Claims

1. A putty-like heat transfer material comprising heat conductive particles dispersed in an organopolysiloxane,
wherein the organopolysiloxane is a silicone sol produced by partially crosslinking a base polymer (a) with a crosslinking component (b),
where the base polymer (a) comprises an organopolysiloxane that contains an average of two or more alkenyl groups each bound to a silicon atom located at a terminal of a molecular chain in a molecule, the crosslinking component (b) comprises an organopolysiloxane that contains an average of two or more hydrogen atoms each bound to a silicon atom in a molecule, and the partial crosslinking is carried out at such a ratio that the amount of the crosslinking component (b) is less than 1 mol with respect to 1 mol of the alkenyl groups bound to silicon atoms contained in the component (a).

2. The putty-like heat transfer material according to claim 1, wherein the heat conductive particles comprise at least two types of inorganic particles having different average particle diameters, and
the inorganic particles having a relatively smaller average particle diameter have been subjected to a surface treatment with a silane compound expressed as R(CH₃)ₐSi(OR')₃₋ₐ (where R is an unsubstituted or substituted organic group having 6 to 20 carbon atoms, R' is an alkyl group having 1 to 4 carbon atoms, and *a* is 0 or 1) or a partial hydrolyzate thereof.

3. The putty-like heat transfer material according to claim 1 or 2, wherein the putty-like heat transfer material has a viscosity in the range of 100 Pa•s to 4,000 Pa•s at a shear rate of 0.2 to 5.0 /s.

4. The putty-like heat transfer material according to any one of claims 1 to 3, wherein the heat conductive particles comprise inorganic particles having an average particle diameter of 2 µm or more and inorganic particles having an average particle diameter of less than 2 µm, and
a content of the inorganic particles having an average particle diameter of 2 µm or more is 50 mass% or more when the entire particles are 100 mass%.

5. The putty-like heat transfer material according to any one of claims 1 to 4, wherein the putty-like heat transfer material has a thermal conductivity in the range of 0.2 to 10 W/mK.

6. The putty-like heat transfer material according to any one of claims 1 to 5, wherein the inorganic particles are formed of at least one material selected from the group consisting of alumina, zinc oxide, magnesium oxide, aluminum nitride, boron nitride, aluminum hydroxide and silica.

7. The putty-like heat transfer material according to claim 6, wherein the alumina is α-alumina with a purity of 99.5 mass% or more.

8. The putty-like heat transfer material according to any one of claims 1 to 7, wherein the putty-like heat transfer material is filled in either a tube or a syringe.

9. The putty-like heat transfer material according to any one of claims 1 to 8, wherein the putty-like heat transfer material includes further an inorganic particulate pigment.

10. The putty-like heat transfer material according to any one of claims 1 to 9, wherein the putty-like heat transfer material exhibits fluidity for extrusion and has a self shape retention when being allowed to stand.

11. The putty-like heat transfer material according to any one of claims 1 to 10, wherein the partial crosslinking is carried out at such a ratio that the amount of the crosslinking component (b) is 0.1 mol or more and less than 0.5 mol with respect to 1 mol of the alkenyl groups bound to silicon atoms contained in the component (a).

12. A method for producing the putty-like heat transfer material according to any one of claims 1 to 11, wherein the putty-like heat transfer material is a silicone sol produced by mixing and partially crosslinking the components comprising (a) to (d) below:
(a) base polymer: 100 mass parts of organopolysiloxane containing an average of two or more alkenyl groups each bound to a silicon atom located at a terminal of a molecular chain in a molecule;
(b) crosslinking component: less than 1 mol of organopolysiloxane containing an average of two or more hydrogen atoms each bound to a silicon atom in a molecule, with respect to 1 mol of the alkenyl groups bound to silicon atoms contained in the component (a);
(c) a platinum-based metal catalyst: 0.01 to 1,000 ppm in mass unit with respect to the component (a); and
(d) heat conductive particles: in the content of 100 to 2,000 mass parts with respect to 100 mass parts of the silicone sol.

13. The method for producing the putty-like heat transfer material according to claim 12, wherein the content of the crosslinking component (b) is 0.1 mol or more and less than 0.5 mol with respect to 1 mol of the alkenyl groups bound to silicon atoms contained in the component (a).

14. The method for producing the putty-like heat transfer material according to claim 12 or 13,
wherein the heat conductive particles comprise at least two types of inorganic particles having different average particle diameters, and
the inorganic particles having a relatively smaller average particle diameter have been subjected to a surface treatment with a silane compound expressed as R(CH₃)ₐSi(OR')₃₋ₐ (where R is an unsubstituted or substituted organic group having 6 to 20 carbon atoms, R' is an alkyl group having 1 to 4 carbon atoms, and *a* is 0 or 1) or a partial hydrolyzate thereof.

15. The method for producing the putty-like heat transfer material according to any one of claims 12 to 14, wherein the organopolysiloxane in the base polymer (a) contains alkenyl groups bound to silicon atoms located at both terminals of the molecular chain.
